# EUROPEAN PATENT APPLICATION

(11) **EP 2 525 411 A2**
(43) Date of publication of application: **21.11.2012**
(21) Application number: 11184636.6
(22) Date of filing: 11.10.2011
(51) Int. Cl.: H01L 31/0224, H01L 31/032, H01L 31/0352, H01L 31/042, H01L 31/0392

(54) **See-through solar battery module and manufacturing method thereof**

(30) Priority: 17.05.2011 TW 100117225
(71) Applicant: Axuntek Solar Energy, Pingtung County 900 (TW)
(72) Inventor: Lee, Shih-Wei, 843 Kaohsiung City (TW); Lin, Ching-Ju, 830 Kaohsiung City (TW); Huang, Wei-Min, 116 Taipei City (TW); Hou, Chi-Hung, 100 Taipei City (TW); Chen, Yen-Chun, 330 Taoyuan County (TW)
(74) Representative: Becker Kurig Straus

(57) **Abstract**

A see-through solar battery module (20) includes a transparent substrate (22), a plurality of stripe-shaped metal electrodes (24) formed on the transparent substrate (22) along a first direction, and a plurality of stripe-shaped photoelectric transducing layers (26) respectively formed on the corresponding stripe-shaped metal electrode (24) and the transparent substrate (22) along the first direction. Two lateral sides of each stripe-shaped photoelectric transducing layer (26) do not contact the transparent substrate (22). The see-through solar battery module (20) further includes a plurality of stripe-shaped transparent electrodes (28) respectively formed on the transparent substrate (22), the corresponding stripe-shaped metal electrode (24), and the corresponding stripe-shaped photoelectric transducing layer (26) along the first direction, so that the plurality of stripe-shaped metal electrodes (24) and the plurality of stripe-shaped transparent electrodes (28) are in series connection along a second direction.

## Description

### Field of the Invention

The invention relates to a see-through solar battery module according to the pre-characterizing clauses of claims 1 and 8.

### Background of the Invention

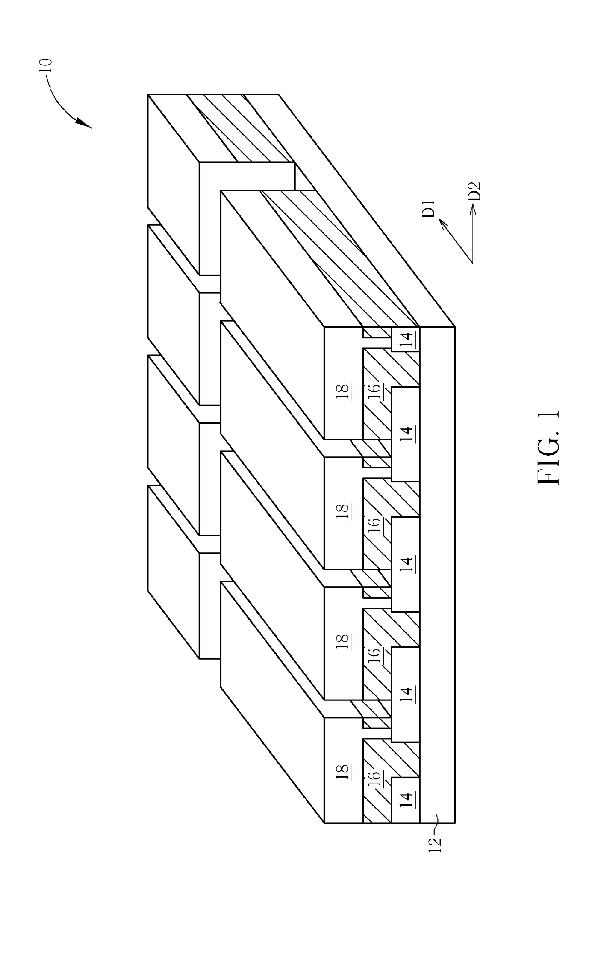

Generally, conventional solar batteries are classified as a see-through solar battery or as a non see-through solar battery. The non see-through solar battery is widely applied in the building materials, such as a tile structure, a hanging, and so on. However, the see-through solar battery is necessarily applied in specific ways, such as a transparent wall, a transparent roof, and so on, for preferable aesthetic appearance. Please refer to FIG.1. FIG.1 is a conventional see-through solar battery module 10 in the prior art. The see-through solar battery module 10 includes a transparent substrate 12, a transparent conductive layer 14, a photoelectric transducing layer 16, and an opaque electrode 18. A method of manufacturing the see-through solar battery module 10 is directly removing parts of the opaque electrode 18 and parts of the photoelectric transducing layer 16 to expose parts of the transparent substrate 12 and parts of the transparent conductive layer 14 for transmitting beams to pass through the see-through solar battery module 10. However, absorbability of solar energy and production of electric energy are decreased by removal of the parts of the photoelectric transducing layer 16, and the conventional see-through solar battery module 10 has low photoelectric transducing efficiency. Thus, design of a see-through battery module having preferable photoelectric transducing efficiency is an important issue of the solar industry.

### Summary of the Invention

This in mind, the present invention aims at providing a see-through solar battery module with improved photoelectric transducing efficiency.

This is achieved by a see-through solar battery module according to claims 1 and 8. The dependent claims pertain to corresponding further developments and improvements.

As will be seen more clearly from the detailed description following below, the claimed a see-through solar battery module that has transparent area on the substrate and electrodes for transmitting beams.

### Brief Description of the Drawings

In the following, the invention is further illustrated by way of example, taking reference to the accompanying drawings. Thereof:
FIG.1 is a conventional see-through solar battery module in the prior art,
FIG.2 is a diagram of a see-through solar battery module according to an embodiment of the invention,
FIG.3 is a flow chart of the method of manufacturing the see-through solar battery module according to a first embodiment of the invention,
FIG.4 to FIG.12 are sectional views of the see-through solar battery module in different procedures according to the first embodiment of the invention,
FIG.13 is a flow chart of the method of manufacturing the see-through solar battery module according to a second embodiment of the invention,
FIG.14 is a diagram of a projecting device according to an embodiment of the invention, and
FIG.15 is a diagram of a projecting device according to another embodiment of the invention.

### Detailed Description

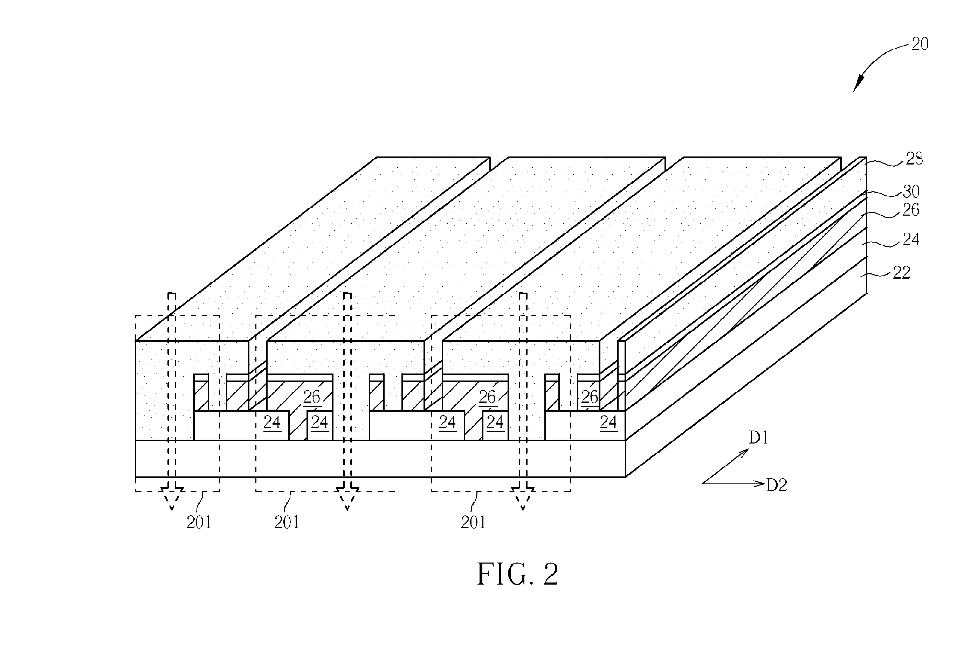

Please refer to FIG.2. FIG.2 is a diagram of a see-through solar battery module 20 according to a preferred embodiment of the invention. The see-through solar battery module 20 includes a transparent substrate 22, a plurality of stripe-shaped metal electrodes 24 separately formed on the transparent substrate 22 along a first direction D1, and a plurality of stripe-shaped photoelectric transducing layers 26 respectively formed on the corresponding stripe-shaped metal electrode 24 and the transparent substrate 22 along the first direction D1. As shown in FIG.2, two lateral sides of each stripe-shaped photoelectric transducing layer 26 do not contact the transparent substrate 22, so as to expose parts of the transparent substrate 22 between the adjacent stripe-shaped metal electrodes 24 and the adjacent stripe-shaped photoelectric transducing layers 26.

The see-through solar battery module 20 further includes a plurality of stripe-shaped transparent electrodes 28 respectively formed on the transparent substrate 22, the corresponding stripe-shaped metal electrode 24 and the corresponding stripe-shaped photoelectric transducing layer 26 along the first direction D1, so that the plurality of stripe-shaped metal electrodes 24 and the plurality of stripe-shaped transparent electrodes 28 are in a series connection along a second direction D2 different from the first direction D1. A contacting area between each stripe-shaped transparent electrode 28 and the corresponding transparent substrate 22 is for transmitting beams, and an area between each stripe-shaped transparent electrode 28 and the corresponding stripe-shaped metal electrodes 24 is for transmitting an electric signal. The see-through solar battery module 20 comprises a plurality of solar batteries 201. The stripe-shaped photoelectric transducing layer 26 of each solar battery 201 is for transforming solar energy into electric power, and the stripe-shaped metal electrode 24 and the stripe-shaped transparent electrode 28 are respectively a positive electrode and a negative electrode of the solar battery 201, so the plurality of solar batteries 201 are in a series connection along the second direction D2, and an outputting voltage of the see-through solar battery module 20 could be adjusted according to user's demand. In addition, the see-through solar battery module 20 could further include a buffer layer 30 disposed between the stripe-shaped photoelectric transducing layer 26 and the stripe-shaped transparent electrode 28.

Generally, the transparent substrate 22 could be made of soda-lime glass, the stripe-shaped metal electrode 24 could be made of molybdenum (Mo) material, the stripe-shaped photoelectric transducing layer 26 could be made of copper indium gallium selenide (CIGS) material, the stripe-shaped transparent electrode 28 could be made of aluminum zinc oxide (AZO) or tin-doped indium oxide (ITO) material, and the buffer layer 30 could be made of zinc sulphide (ZnS) material and intrinsic zinc oxide (ZnO) material. Material of the transparent substrate 22, the stripe-shaped metal electrode 24, the stripe-shaped photoelectric transducing 26, the stripe-shaped transparent electrode 28 and the buffer layer 30 are not limited to the above-mentioned embodiment, and depend on design demand. Due to the transparent property of the soda-lime glass, AZO (or ITO), and the intrinsic ZnO, the beams can pass through transparent areas of the see-through solar battery module 20 (shown as arrows in FIG.2), and the user can see through the see-through solar battery module 20.

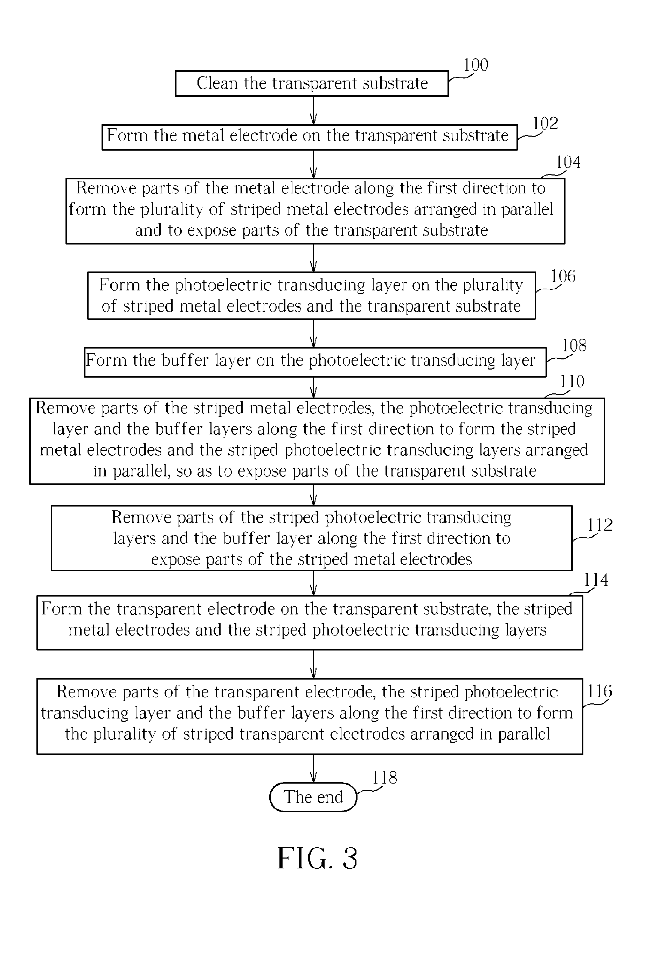

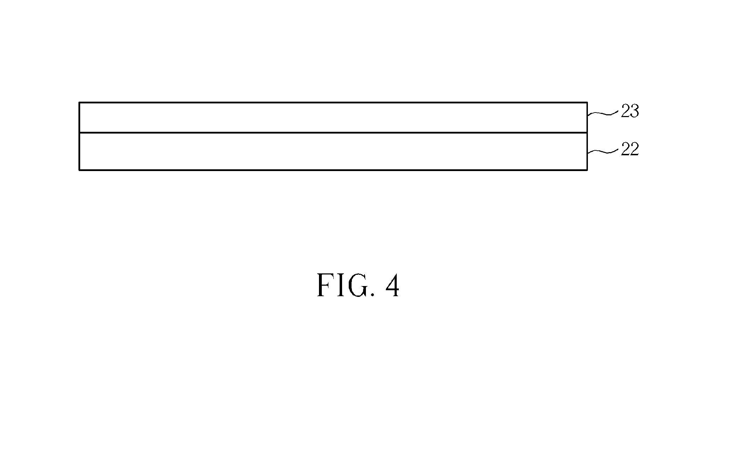

Please refer to FIG.2 and FIG.3 to FIG.12. FIG.3 is a flow chart of the method of manufacturing the see-through solar battery module 20 according to a first embodiment of the invention. FIG.4 to FIG.12 are sectional views of the see-through solar battery module 20 in different procedures along the second direction according to the first embodiment of the invention. The method includes the following steps:
- Step 100:: Clean the transparent substrate 22.
- Step 102:: Form a metal electrode 23 on the transparent substrate 22.
- Step 104:: Remove parts of the metal electrode 23 along the first direction D1 to separately form the plurality of stripe-shaped metal electrodes 24 arranged in parallel and to expose parts of the transparent substrate 22.
- Step 106:: Form a photoelectric transducing layer 25 on the plurality of stripe-shaped metal electrodes 24 and the transparent substrate 22.
- Step 108:: Form the buffer layer 30 made of the ZnS material and the intrinsic ZnO material on the photoelectric transducing layer 25.
- Step 110:: Remove parts of the stripe-shaped metal electrodes 24, parts of the photoelectric transducing layer 25 and parts of the buffer layer 30 along the first direction D1 to form the plurality of stripe-shaped metal electrodes 24 and the plurality of stripe-shaped photoelectric transducing layers 26 arranged in parallel, so as to expose the parts of the transparent substrate 22, wherein two lateral sides of each stripe-shaped photoelectric transducing layer 26 do not contact the transparent substrate 22.
- Step 112:: Remove parts of the stripe-shaped photoelectric transducing layers 26 and parts of the buffer layer 30 along the first direction D1 to expose parts of the plurality of stripe-shaped metal electrodes 24.
- Step 114:: Form a transparent electrode 27 on the transparent substrate 22, the plurality of stripe-shaped metal electrodes 24 and the plurality of stripe-shaped photoelectric transducing layers 26.
- Step 116:: Remove parts of the transparent electrode 27, parts of the stripe-shaped photoelectric transducing layer 26 and parts of the buffer layer 30 along the first direction D1 to form the plurality of stripe-shaped transparent electrodes 28 arranged in parallel, so that the stripe-shaped metal electrode 24 and the stripe-shaped transparent electrode 28 of the adjacent solar batteries 201 are in series connection along the second direction D2.
- Step 118:: The end.

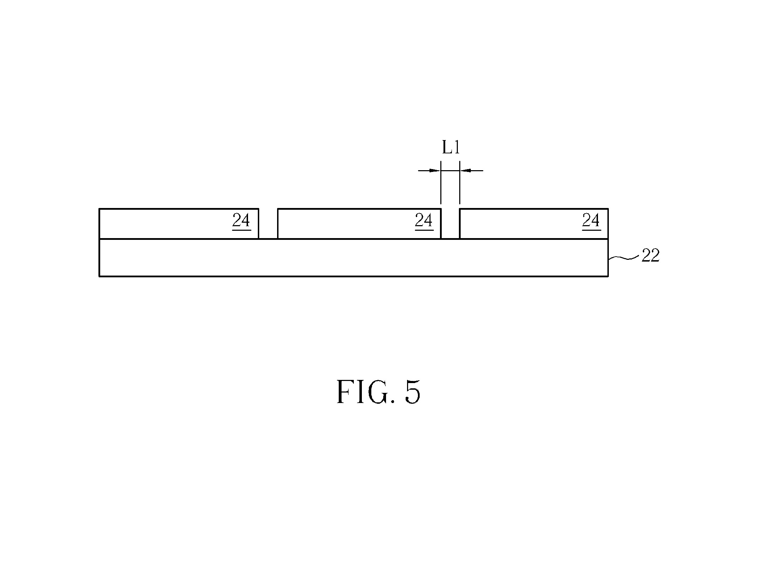

Detailed description of the method is introduced as follows, and step 100 to step 116 corresponds to FIG.4 to FIG.12 respectively. First, the transparent substrate 22 is cleaned for preventing dirt from heaping on the transparent substrate 22. At this time, a barrier layer made of AI203 or Si02 material could be selectively formed on the transparent substrate 22 for isolating the current. Further, NaF material could be formed on the transparent substrate 22 by evaporation method for crystallizing the CIGS material on the transparent substrate 22. Then, as shown in FIG.4 and FIG.5, the metal electrode 23 made of the Mo material could be formed on the transparent substrate 22 by sputtering or another technology, and the parts of the metal electrode 23 (a section L1 of the metal electrode 23 is removed in step 104) could be removed along the first direction D1 by laser technology or other removing technology, so as to expose the parts of the transparent substrate 22 and to form the plurality of stripe-shaped metal electrodes 24 arranged in parallel.

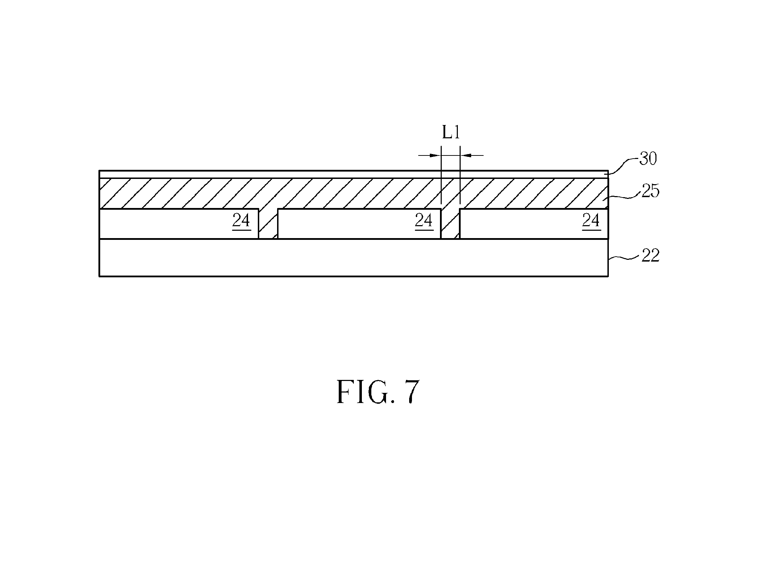

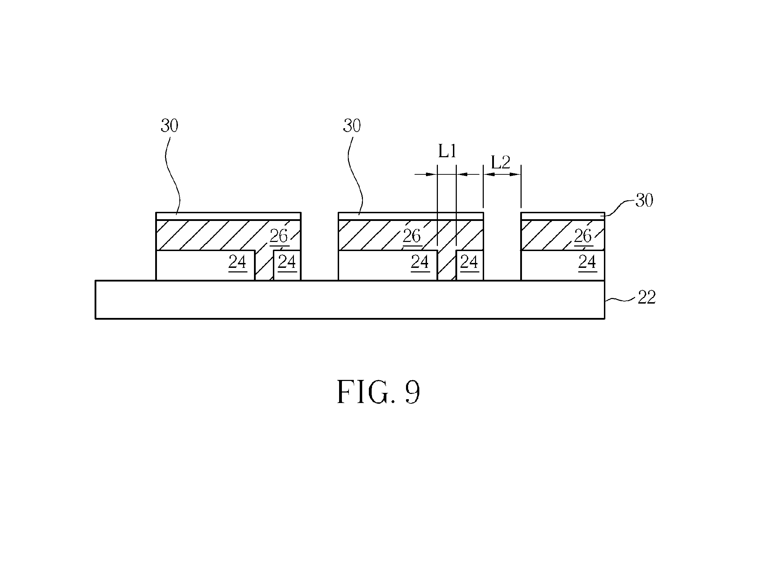

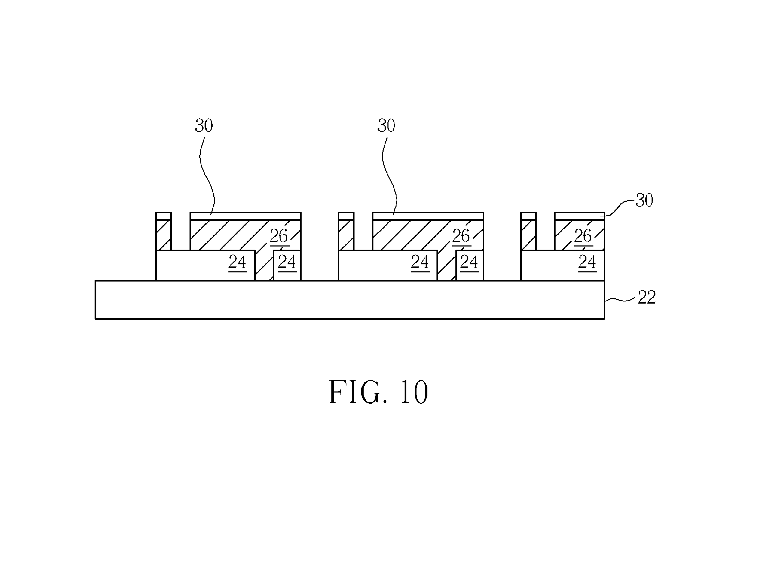

As shown in FIG.7 and FIG.9, the photoelectric transducing layer 25 could be formed on the plurality of stripe-shaped metal electrodes 24 and the exposed transparent substrate 22 by thin film deposition method or other technology, and the buffer layer 30 made of the ZnS material and the intrinsic ZnO material could be formed on the photoelectric transducing layer 25. As shown in FIG.10, the parts of the stripe-shaped metal electrode 24, the parts of the photoelectric transducing layer 25 and the parts of the buffer layer 30 could be simultaneously removed along the first direction D1 by laser technology or another removing technology to form the plurality of stripe-shaped metal electrodes 24 and the plurality of stripe-shaped photoelectric transducing layers 26 arranged in parallel, and to expose the parts of the transparent substrate 22. Compared step 104, sections L2 of the stripe-shaped metal electrode 24 and the photoelectric transducing layer 25 could be simultaneously removed in step 110, and the section L2 is substantially greater than the section L1. Meanwhile, the two lateral sides of each stripe-shaped photoelectric transducing layer 26 do not contact the transparent substrate 22. After, the parts of the stripe-shaped photoelectric transducing layer 26 and the parts of the buffer layer 30 could be removed along the first direction D1 by a scraper method or another removing method to expose the parts of the stripe-shaped metal electrodes 24. The intrinsic ZnO material is a transparent film having preferable photoelectric property for increasing photoelectric transducing efficiency and electricity generating efficiency of the see-through solar battery module 20. Generally, the thin film deposition could be realized by co-evaporation, vacuum sputter, and selenization methods to achieve preferable photoelectric transducing efficiency of the CIGS film.

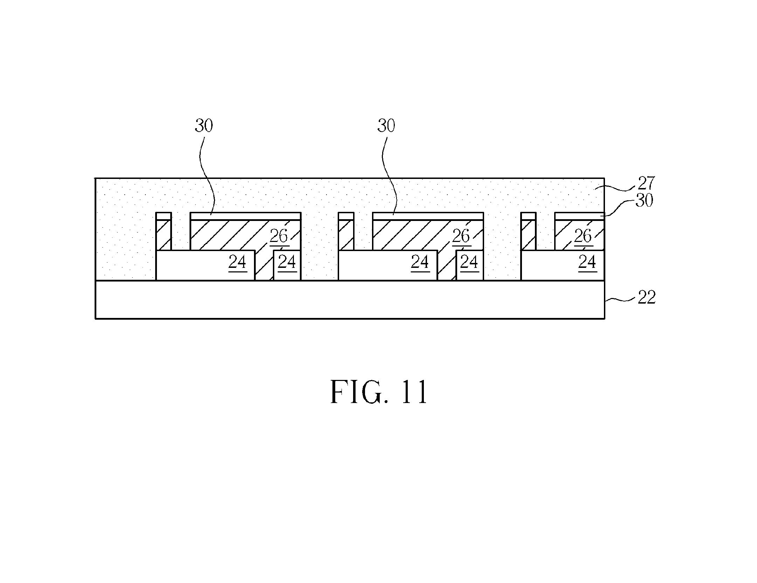

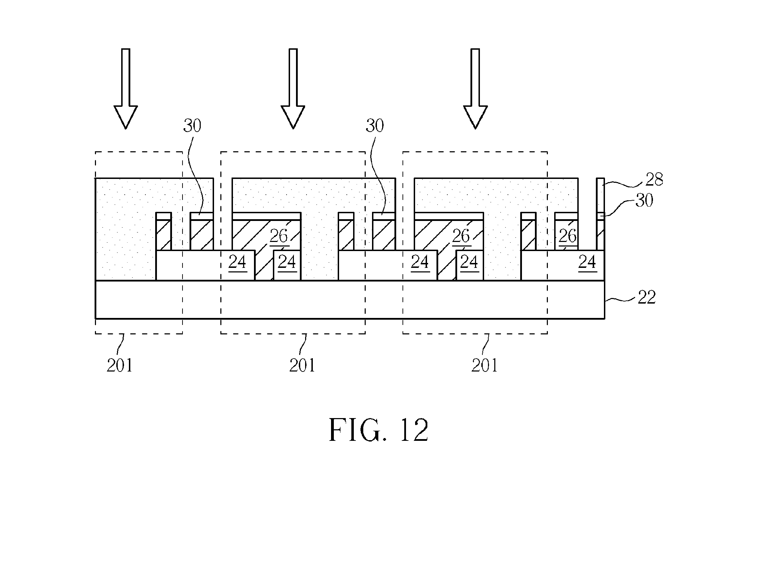

Finally, as shown in FIG.11 and FIG.12, the transparent electrode 27 could be formed on the transparent substrate 22, the plurality of stripe-shaped metal electrodes 24, the plurality of stripe-shaped photoelectric transducing layer 26 and the buffer layer 30, and then parts of the transparent electrode 27, the parts of the stripe-shaped photoelectric transducing layer 26 and the parts of the buffer layer 30 could be removed along the first direction D1 simultaneously, so as to form the plurality of stripe-shaped transparent electrodes 28 arranged in parallel and to expose the parts of the stripe-shaped metal electrodes 24. Thus, the see-through solar battery module 20 could include the plurality of solar batteries 201, and the stripe-shaped metal electrode 24 and the stripe-shaped transparent electrode 28 of the adjacent solar batteries 201 are in a series connection along the second direction D2. The transparent areas of each solar battery 201 are formed by the stripe-shaped transparent electrode 28 and the transparent substrate 22 allowing the beams to pass through (shown as arrows in FIG.12). Material and manufacturing procedures of the buffer layer 30 is not limited to the above-mentioned embodiment, which is a selectable procedure, and it depends on design demand.

The see-through solar battery module 20 of the invention redesigns the conventional procedures for beam transmittance. The parts of the stripe-shaped metal electrodes 24 and the parts of the photoelectric transducing layer 25 could be removed in step 110, so that the transparent electrode 27 could be directly formed on the transparent substrate 22 in later procedures allowing the beams to pass. The procedure of the see-through solar battery module 20 of the invention could utilize a laser machine to execute step 104 and step 110. The laser machine could be for cutting the metal electrode 23, and for simultaneously removing the stripe-shaped metal electrode 24, the photoelectric transducing layer 25 and the parts of the buffer layer 30 by adjusting intensity of laser beam, so the invention needs few machines, and has advantages of a short manufacturing period and low manufacturing costs. In addition, the photoelectric transducing layer 26 is not removed specially for allowing the beams to pass in the invention. The photoelectric transducing layer 26 of the see-through solar battery module 20 includes greater superficial measurements, which means the invention has preferred photoelectric transducing efficiency. Because the transparent areas of the see-through solar battery module 20 of the invention are located between the adjacent solar batteries 201, illumination fringes are parallel to disposition of the solar battery 201. However, the illumination fringes of the see-through solar battery module 20 is not limited to the direction of the solar battery 201, for example, the illumination fringes could be formed as dotted patterns. Further, the dotted patterns could be arranged to form a symbol or a character for increasing practicability of the invention.

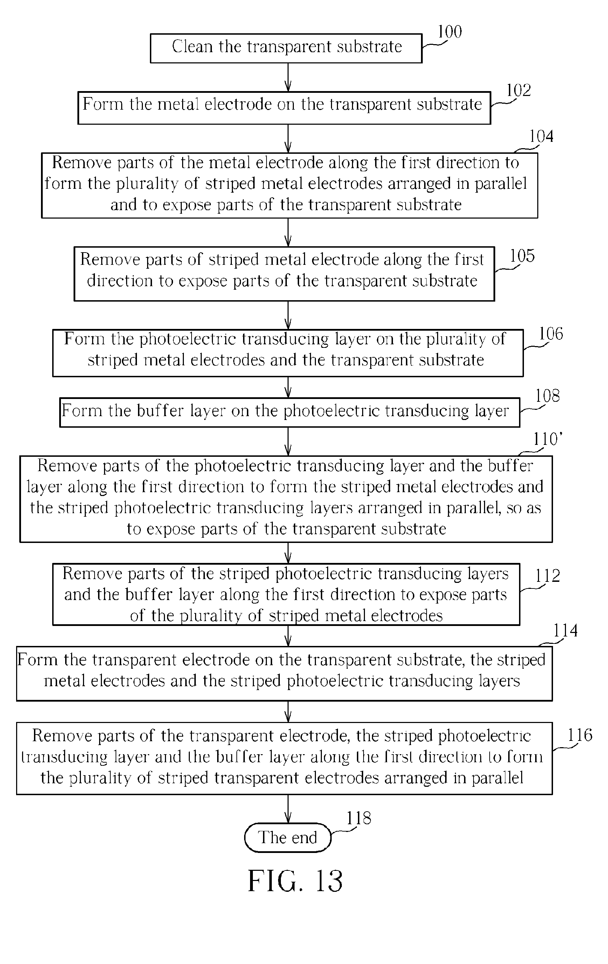

Please refer to FIG.13. FIG.13 is a flow chart of the method of manufacturing the see-through solar battery module 20 according to a second embodiment of the invention. The method includes the following steps:
- Step 100:: Clean the transparent substrate 22.
- Step 102:: Form a metal electrode 23 on the transparent substrate 22.
- Step 104:: Remove the parts of the metal electrode 23 (the section L1) along the first direction D1 to form the plurality of stripe-shaped metal electrodes 24 arranged in parallel and to expose the parts of the transparent substrate 22.
- Step 105:: Remove the parts of stripe-shaped metal electrode 24 (the section L2) along the first direction D1 to expose the parts of the transparent substrate 22.
- Step 106:: Form the photoelectric transducing layer 25 on the plurality of stripe-shaped metal electrodes 24 and the transparent substrate 22.
- Step 108:: Form the buffer layer 30 made of the ZnS material and the intrinsic ZnO material on the photoelectric transducing layer 25.
- Step 110':: Remove the parts of the photoelectric transducing layer 25 and the parts of the buffer layer 30 along the first direction D1 to form the plurality of stripe-shaped metal electrodes 24 and the plurality of stripe-shaped photoelectric transducing layers 26 arranged in parallel, so as to expose the parts of the transparent substrate 22, wherein the two lateral sides of each stripe-shaped photoelectric transducing layer 26 do not contact the transparent substrate 22.
- Step 112:: Remove parts of the stripe-shaped photoelectric transducing layers 26 and the parts of the buffer layer 30 along the first direction D1 to expose the parts of the plurality of stripe-shaped metal electrodes 24.
- Step 114:: Form the transparent electrode 27 on the transparent substrate 22, the plurality of stripe-shaped metal electrodes 24 and the plurality of stripe-shaped photoelectric transducing layers 26.
- Step 116:: Remove the parts of the transparent electrode 27, the parts of the stripe-shaped photoelectric transducing layer 26 and the parts of the buffer layer 30 along the first direction D1 to form the plurality of stripe-shaped transparent electrodes 28 arranged in parallel, so that the stripe-shaped metal electrode 24 and the stripe-shaped transparent electrode 28 of the adjacent solar batteries 201 are in series connection along the second direction D2.
- Step 118:: The end.

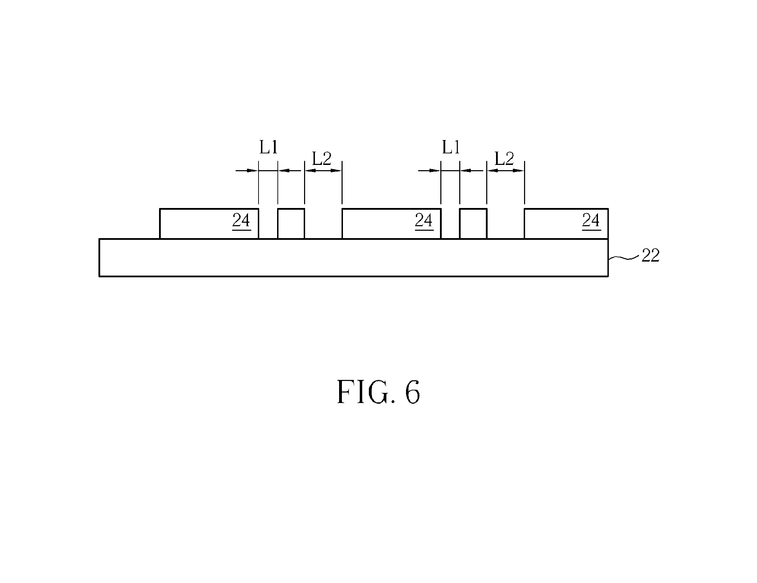

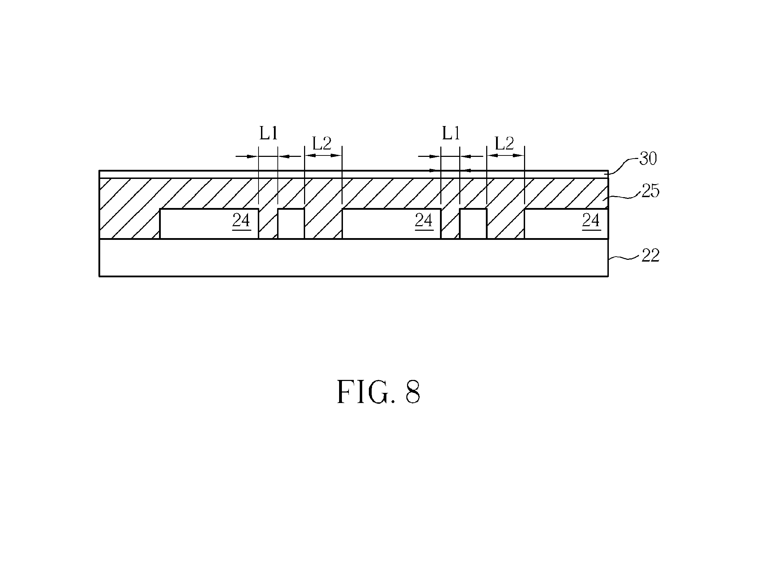

In the second embodiment, steps having the same numerals as steps in the first embodiment have the same functions and operations, and detailed description is omitted herein for simplicity. One difference between the first embodiment and the second embodiment is that the second embodiment has step 105, and replaces step 110 in the first embodiment with step 110'. Please refer to FIG.6 and FIG.8, FIG.6 and FIG.8 are respectively diagrams of the see-through solar battery module 20 in two specific procedures along the second direction D2 according to the second embodiment of the invention. As shown in FIG.6 (step 104 and step 105), the section L1 and the section L2 of the metal electrode 23 could be removed from the transparent substrate 22 along the first direction D1 by the laser technology, and the section L2 is substantially greater than the section L1. As shown in FIG.8 (step 106 and step 108), the photoelectric transducing layer 25 could be formed on the plurality of stripe-shaped metal electrode 24 and the transparent substrate 22, and could be simultaneously full of gaps in the section L1 and the section L2. The buffer layer 30 could be formed on the photoelectric transducing layer 25. Final, as shown in FIG.9 (step 110'), because the section L2 of the stripe-shaped metal electrode 24 has been removed by the laser technology in step 105, the parts of the photoelectric transducing layer 25 and the parts of the buffer layer 30 could be removed by the mechanical technology, such as the scraper, to form the plurality of stripe-shaped metal electrodes 24 and the plurality of stripe-shaped photoelectric transducing layers 26 arranged in parallel and to expose the parts of the transparent substrate 22. Therefore, the section L2 of the stripe-shaped metal electrode 24 is removed in the second embodiment of the invention in anticipation, so that the photoelectric transducing layer 25 and the buffer layer 30 could be removed in step 110' by the mechanical technology with low power consumption and easy operation.

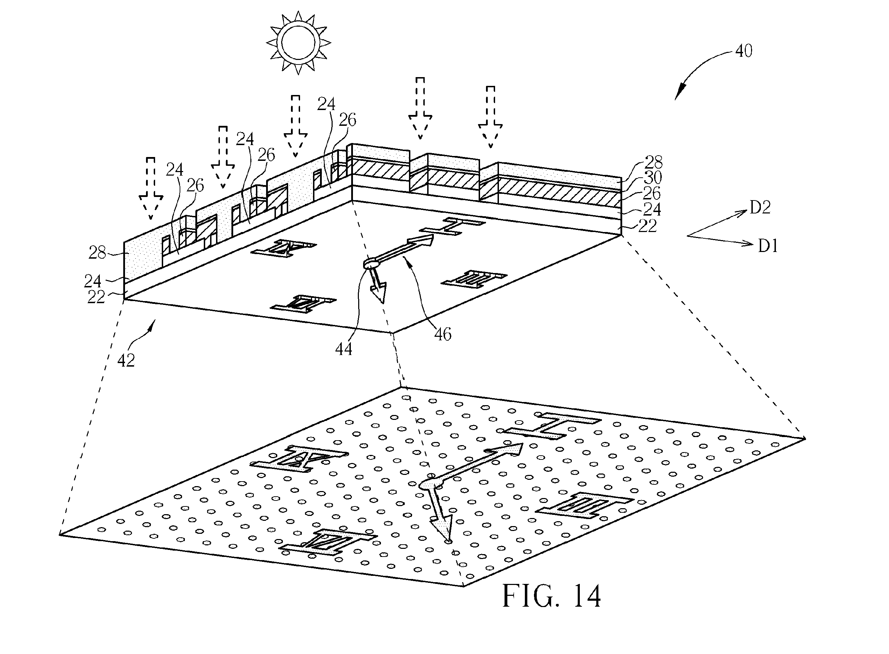

Please refer to FIG.14. FIG.14 is a diagram of a projecting device 40 according to an embodiment of the invention. The projecting device 40 includes a see-through solar battery module 42, a motor 44 disposed on a bottom of the see-through solar battery module 42, and a pointer 46 disposed on the motor 44. Functions and disposal of components of the see-through solar battery module 42 are the same as ones of the see-through solar battery module 20, and the detailed description is omitted herein for simplicity. For manufacturing the see-through solar battery module 42, parts of the stripe-shaped metal electrode 24, parts of the stripe-shaped photoelectric transducing layer 26, and parts of the stripe-shaped transparent electrode 28 could be removed along the second direction D2 after the above-mentioned manufacturing method, so as to expose parts of the transparent substrate 22. That is to say, the manufacturing method of the see-through solar battery module 42 along the first direction D1 is forming the plurality of stripe-shaped metal electrodes 24 on the transparent substrate 22, wherein each stripe-shaped metal electrode 24 does not contact the adjacent stripe-shaped metal electrodes 24 along the first direction D1, forming the plurality of stripe-shaped photoelectric transducing layers 26 on the corresponding stripe-shaped metal electrodes 24 respectively, wherein each stripe-shaped photoelectric transducing layer 26 does not contact the adjacent stripe-shaped photoelectric transducing layers 26 along the first direction D1, and forming the plurality of stripe-shaped transparent electrode 28 on the corresponding stripe-shaped photoelectric transducing layers 26 respectively, wherein each stripe-shaped transparent electrode 28 does not contact the transparent substrate 22, the corresponding stripe-shaped metal electrode 24, and the adjacent stripe-shaped transparent electrodes 28 along the first direction D1.As shown in FIG.14, the transparent areas with the dotted patterns could be formed on the see-through solar battery module 42 according to the above-mentioned method to transmit the beams to pass through the see-through solar battery module 42 along the direction of the arrow.

In addition, the dotted patterns could be utilized to form different symbols, such as a numeral. When the projecting device 40 projects the image of the numeral on a projecting curtain, and the pointer 46 is rotated regularly for moving its shadow to point the projecting images of different numerals, the projecting device 40 could be a dynamic projecting pointer, such as a clock. Furthermore, the see-through solar battery module 42 could supply power to the motor 44 for driving the pointer 46, so that the projecting device 40 could be a solar clock. Besides, the pointer 46 could be set on the projecting curtain, and the protecting device 40 could project the images of different numerals on the projecting curtain, so as to form a clock-typed print. In conclusion, the invention could design the see-through solar battery module to project the images with different patterns, such as a symbol or a character, so that the invention has preferable photoelectric transducing efficiency and wonderful aesthetic appearance.

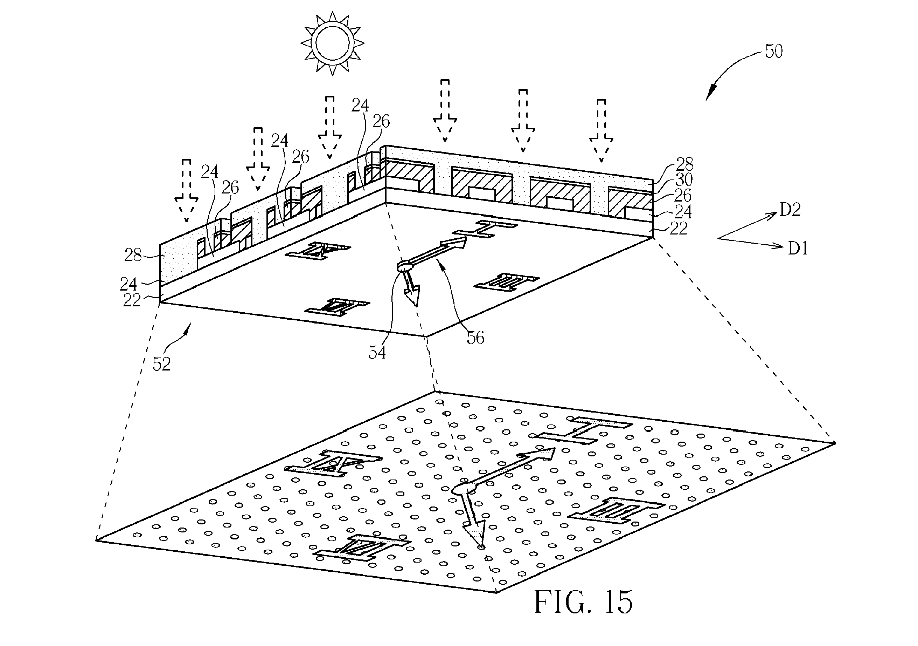

Please refer to FIG.15 that is a diagram of a projecting device 50 according to another embodiment of the invention. The projecting device 50 includes a see-through solar battery module 52, a motor 54 disposed on a bottom of the see-through solar battery module 52, and a pointer 56 disposed on the motor 54. Functions and disposals of components of the see-through solar battery module 52 are the same as the ones of the above-mentioned see-through solar battery module 20, and the detailed description is omitted herein for simplicity. In order to project the image with the dotted patterns by the see-through solar battery module 52, parts of the metal electrode 23 could be removed along the first direction D1 and the second direction D2 to form the plurality of block metal electrodes 24 arranged as an array, and parts of photoelectric transducing layer 25 could be removed along the first direction D1 to form the plurality of stripe-shaped photoelectric transducing layers 26 arranged in parallel. Finally, parts of the plurality of stripe-shaped photoelectric transducing layers 26 could be removed along the second direction D2 so as to expose the parts of the transparent substrate 22.

The see-through solar battery module 52 includes the plurality of stripe-shaped metal electrodes 24 formed on the transparent substrate 22 wherein each stripe-shaped metal electrode 24 does not contact the adjacent stripe-shaped metal electrodes 24 along the first direction D1, the plurality of stripe-shaped photoelectric transducing layers 26 respectively formed on the corresponding stripe-shaped metal electrode 24 and the transparent bass 22 wherein each stripe-shaped photoelectric transducing layer 26 does not contact the adjacent stripe-shaped photoelectric transducing layers 26 along the first direction D1, and the plurality of stripe-shaped transparent electrodes 28 respectively formed on the corresponding stripe-shaped photoelectric transducing layer 26 and the transparent substrate 22 wherein each stripe-shaped transparent electrode 28 does not contact the corresponding stripe-shaped metal electrode 24 along the first direction D1. Thus, as shown in FIG.15, the transparent areas with the dotted patterns could be formed on the see-through solar battery module 52 in any direction for transmitting the beams along the direction of the arrow according to the above-mentioned method. In addition, the dotted patterns could be utilized to form different symbols, such as a numeral. As the above-mentioned embodiment, when the projecting device 50 projects the numeral images on the projecting curtain, and the pointer 56 is rotated regularly for moving its shadow to point the projecting images with different numerals, the projecting device 50 could be a dynamic projecting pointer, such as a clock. As the see-through solar battery module 52 supplies power to the motor 54 for driving the pointer 56, the projecting device 40 could be a solar clock. Besides, the pointer 56 could be set on the projecting curtain, and the protecting device 50 could project the images with different numerals on the projecting curtain, so as to form a clock-typed print.

Comparing to the prior art, the invention forms the transparent areas on the see-through solar battery module by redesigning the conventional manufacturing method. The method of the invention has simple procedures, which removes the metal electrode and the photoelectric transducing layer simultaneously for economizing the material cost and decreasing manufacturing period, so that the invention has advantages of high photoelectric transducing efficiency, high production yield, and low manufacturing cost. In addition, the invention could form a projected image with various patterns, such as a symbol or a character, for increasing the practicability of the see-through solar battery module.

## Claims

1. A see-through solar battery module (20), comprising:
a transparent substrate (22);
**characterized by**:
a plurality of stripe-shaped metal electrodes (24) separately formed on the transparent substrate (22) along a first direction;
a plurality of stripe-shaped photoelectric transducing layers (26) respectively formed on the corresponding stripe-shaped metal electrode (24) and the transparent substrate (22) along the first direction, two lateral sides of each stripe-shaped photoelectric transducing layer (26) not contacting the transparent substrate (22); and
a plurality of stripe-shaped transparent electrodes (28) respectively formed on the transparent substrate (22), the corresponding stripe-shaped metal electrode (24) and the corresponding stripe-shaped photoelectric transducing layer (26) along the first direction so that the stripe-shaped metal electrodes (24) and the stripe-shaped transparent electrodes (28) are in series connection along a second direction different from the first direction, a contacting area between each stripe-shaped transparent electrode (28) and the corresponding transparent substrate (22) being for transmitting beams.

2. The see-through solar battery module (20) of claim 1 further **characterized in that** each stripe-shaped metal electrode (24) does not contact the adjacent stripe-shaped metal electrode (24) along the first direction, each stripe-shaped photoelectric transducing layer (26) does not contact the transparent substrate (22) and the adjacent stripe-shaped photoelectric transducing layer (26) along the first direction, and each stripe-shaped transparent electrode (28) does not contact the transparent substrate (22), the corresponding stripe-shaped metal electrode (24) and the adjacent stripe-shaped transparent electrode (28) along the first direction.

3. The see-through solar battery module (20) of claim 1 further **characterized in that** each stripe-shaped metal electrode (24) does not contact the adjacent stripe-shaped metal electrode (24) along the first direction, each stripe-shaped photoelectric transducing layer (26) does not contact the adjacent stripe-shaped photoelectric transducing layer (26) along the first direction, and each stripe-shaped transparent electrode (28) does not contact the corresponding stripe-shaped metal electrode (24) along the first direction.

4. The see-through solar battery module (20) of claim 1 further **characterized by**:
a buffer layer (30) formed between the stripe-shaped photoelectric transducing layer (26) and the stripe-shaped transparent electrode (28), the buffer layer (30) being made of zinc sulphide material and intrinsic zinc oxide material.

5. The see-through solar battery module (20) of claim 1 further **characterized in that** the stripe-shaped metal electrode (24) is made of molybdenum material.

6. The see-through solar battery module (20) of claim 1 further **characterized in that** the stripe-shaped photoelectric transducing layer (26) is made of copper indium gallium selenide material.

7. The see-through solar battery module (20) of claim 1 further **characterized in that** the stripe-shaped transparent electrode (28) is a transparent conductive layer made of aluminum zinc oxide or tin-doped indium oxide material.

8. A method of manufacturing a see-through solar battery module (20), **characterized by**:
forming a metal electrode (23) on a transparent substrate (22);
removing parts of the metal electrode (23) along a first direction to form a
plurality of stripe-shaped metal electrodes (24) arranged in parallel;
forming a photoelectric transducing layer (25) on the stripe-shaped metal
electrodes (24) and the transparent substrate (22);
removing parts of the photoelectric transducing layer (25) along the first
direction so as to expose parts of the transparent substrate (22);
removing parts of the photoelectric transducing layer (25) along the first
direction to form a plurality of stripe-shaped photoelectric transducing layers (26) arranged in parallel so as to expose parts of the stripe-shaped metal electrodes (24);
forming a transparent electrode (27) on the transparent substrate (22), the
stripe-shaped metal electrodes (24) and the stripe-shaped photoelectric transducing layers (26); and
removing parts of the transparent electrode (27) along the first direction to form
a plurality of stripe-shaped transparent electrodes (28) arranged in parallel so that the stripe-shaped metal electrodes (24) and the stripe-shaped transparent electrodes (28) are in series connection along a second direction different from the first direction.

9. The method of claim 8 further **characterized by**:
forming a buffer layer (30) between the photoelectric transducing layer (25)
and the transparent electrode (27).

10. The method of claim 8 further **characterized by**:
removing parts of the stripe-shaped transparent electrodes (28), parts of the stripe-shaped photoelectric transducing layers (26) and parts of the stripe-shaped metal electrodes (24) so as to expose parts of the transparent substrate (22) for forming a pattern.

11. The method of claim 8 further **characterized by**:
removing parts of the stripe-shaped metal electrodes (24) along the second direction to form a plurality of block metal electrodes (23) arranged in an array after removing the parts of the metal electrode (23) along the first direction to form the plurality of stripe-shaped metal electrodes (24) arranged in parallel; and
removing parts of the stripe-shaped photoelectric transducing layers (26) along the second direction to expose parts of the transparent substrate (22) after removing the parts of the photoelectric transducing layer (25) along the first direction to form the plurality of stripe-shaped photoelectric transducing layers (26) arranged in parallel.

12. The method of claim 8 further **characterized in that** removing the parts of the metal electrode (23) along the first direction to form the plurality of stripe-shaped metal electrodes (24) arranged in parallel comprises:
utilizing a laser to remove the metal electrode (23) into the stripe-shaped metal electrodes (24) arranged in parallel along the first direction.

13. The method of claim 8 further **characterized in that** removing the parts of the photoelectric transducing layer (25) along the first direction comprises:
utilizing a laser to remove the parts of the photoelectric transducing layer (25) and parts of the corresponding stripe-shaped metal electrodes (24) simultaneously.

14. The method of claim 8 further **characterized by**:
utilizing a scraper to remove the parts of the photoelectric transducing layer (25) and the parts of the transparent electrode (27) along the first direction.

15. The method of claim 8 further **characterized in that** removing the parts of the transparent electrode (27) along the first direction comprises:
removing the parts of the transparent electrode (27) and the parts of the corresponding photoelectric transducing layer (25) simultaneously along the first direction.
